# EUROPEAN PATENT APPLICATION

(11) **EP 2 887 482 A1**
(43) Date of publication of application: **24.06.2015**
(21) Application number: 13879655.2
(22) Date of filing: 31.07.2013
(51) Int. Cl.: H02H 3/05, G01R 31/327, G01R 31/333

(54) **DIGITAL PROTECTION RELAY, DIGITAL PROTECTION RELAY TEST DEVICE, AND METHOD FOR TESTING DIGITAL PROTECTION RELAY**

(30) Priority: 17.08.2012 JP 2012180856
(71) Applicant: Kabushiki Kaisha Toshiba, Minato-ku Tokyo 105-8001 (JP)
(72) Inventor: NAKAMURA, Seiichi, Tokyo 105-8001 (JP); WAKAMATSU, Naoki, Tokyo 105-8001 (JP); ISHIDA, Satoshi, Tokyo 105-8001 (JP)
(74) Representative: Willquist, Sofia Ellinor
(86) International application number: PCT/JP2013/070789
(87) International publication number: WO 2014/027571

(57) **Abstract**

According to one embodiment, a digital protection relay includes an auxiliary transformer (2) which decreases a voltage of an electrical signal from a main circuit transformer (1) to a predetermined voltage; a detection resistance circuit (20) including a Π-type or T-type circuit including an input connected to an output of the auxiliary transformer (2); an analog detection circuit (3) which is connected to an output of the detection resistance circuit (20) and detects a quantity of electricity of an electrical signal from the auxiliary transformer (2) ; an A/D conversion circuit (4) connected to the analog detection circuit (3); a central processing device 5 which is connected to the A/D conversion circuit (5) and performs a protection operation; and a trip output contact (9) which is closed by processing of the central processing device (5) and operates an external breaker (21). In the digital protection relay, an input contact terminal 11 for inputting a test signal with a constant voltage from an external test device (13) to the analog detection circuit (3) as a signal corresponding to an output of the auxiliary transformer (2) is provided between the detection resistance circuit (20) and the analog detection circuit (3).

## Description

### Technical Field

Embodiments of the present invention relate to a digital protection relay, a digital protection relay test device, and a digital protection relay test method for detecting an abnormality in a main circuit system and performing a protection operation.

### Background Art

When a test as a check of whether a digital protection relay normally operates is conducted, a test device is conventionally connected to a terminal to which an output of a transformer connected to amain circuit is connected. Under this condition, a protection function of the digital protection relay is checked.

An example of the procedure of the digital protection relay test will be described. First, a test terminal is provided on a primary side of an auxiliary transformer provided outside the digital protection relay. Then, in a state where the main circuit is powered off, a test signal with a current of several tens of amperes or with a voltage of a hundred and several tens of volts is applied to the test terminal.

To conduct a digital protection relay test, as described above, a test signal needs to be applied to the test terminal provided on the primary side of the auxiliary transformer of the digital protection relay. Moreover, the test terminal of the digital protection relay, such as a trip output contact, is usually provided in a panel of the digital protection relay.

Therefore, to conduct a digital protection relay test, a relay test device capable of generating a large current/voltage is required. Since the test terminal of the digital protection relay is provided inside the door of the panel, it is necessary to open and close the door of the panel to connect the test terminal with the test device.

Furthermore, if a failure occurs in the main circuit during a test of the digital protection relay, the main circuit cannot be protected. Therefore, when a test is conducted, the main circuit needs to be powered off in advance.

Consequently, the time for conducting a digital protection relay test is limited to times in which the influence of the power outage of the main circuit is small, such as during holidays and late at night. In addition, the test time (power outage time) needs to be minimized.

### [Prior Art Reference]

### [Patent Literature]

### [Patent Literature 1]

Jpn. Pat. Appln. KOKAI Publication No. 2009-171723

### Summary of Invention

An object to be solved is to provide a digital protection relay, a digital protection relay test device, and a digital protection relay test method which enable a safe and easy operational test without powering off the main circuit in advance.

According to an embodiment, the digital protection relay comprises: an auxiliary transformer which decreases a voltage of an electrical signal from a main circuit transformer; and a detection resistance circuit including a Π-type or T-type circuit including an input connected to an output of the auxiliary transformer. The digital protection relay comprises an analog detection circuit which is connected to an output of a detection resistance circuit and detects a quantity of electricity of an electrical signal from an auxiliary transformer; an A/D conversion circuit connected to the analog detection circuit; a central processing device which is connected to the A/D conversion circuit and performs a protection operation; and a trip output contact which is closed by processing of the central processing device and operates an external breaker. In the digital protection relay, an input contact terminal for inputting a test signal with a constant voltage from an external test device to an analog detection circuit as a signal corresponding to an output of the auxiliary transformer is provided between the detection resistance circuit and the analog detection circuit.

### Brief Description of Drawings

FIG. 1 is a block diagram showing an exemplary configuration of a digital protection relay according to an embodiment.
FIG. 2 is a perspective view showing an example of an exterior of the digital protection relay according to the embodiment.
FIG. 3 is a flowchart showing an example of an operational procedure of a portable test device of the digital protection relay according to the embodiment.

### Mode for Carrying Out the Invention

Hereinafter, an embodiment will be described with reference to the drawings.

The present embodiment enables an operational test of a digital protection relay while continuing protection of a main circuit without powering off the main circuit.

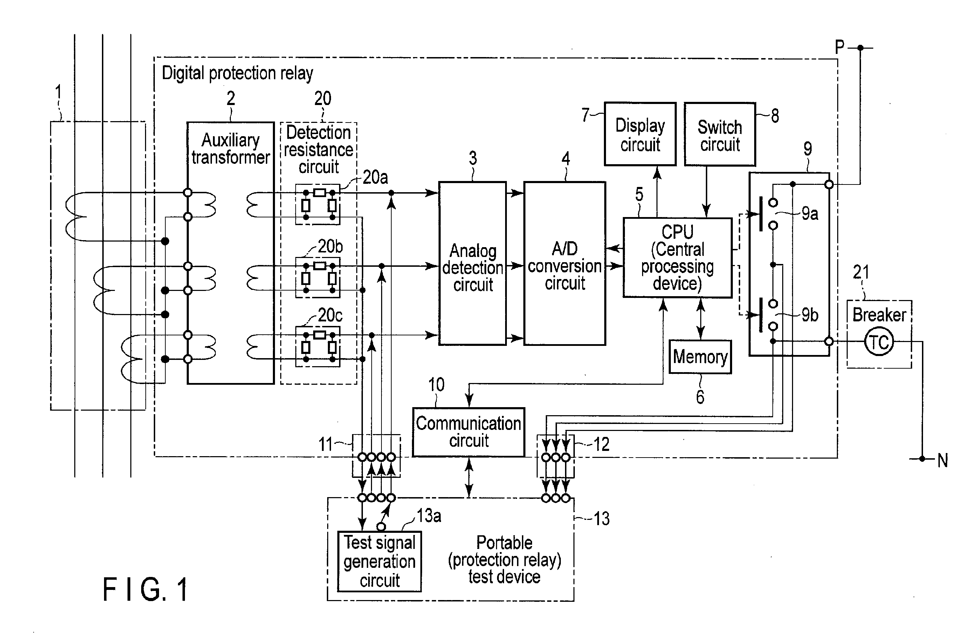

FIG. 1 is a block diagram showing an exemplary configuration of a digital protection relay according the present embodiment.

As shown in FIG. 1, the digital protection relay of the present embodiment comprises a main circuit transformer 1, an auxiliary transformer 2, an analog detection circuit 3, an A/D conversion circuit 4, a central processing unit (CPU) 5, a memory 6, a display circuit 7, a switch circuit 8, a breaker trip output contact 9, a communication circuit 10, and a test contact.

The main circuit transformer 1 is connected to the main circuit. The auxiliary transformer 2 decreases a voltage of an electrical signal from the main circuit transformer 1 to a predetermined electronic circuit level.

Between the output side of the auxiliary transformer 2 and the input side of the analog detection circuit 3, detection resistance circuits 20a, 20b, and 20c corresponding to three phases are connected. The detection resistance circuits 20a, 20b, and 20c are collectively called a detection resistance circuit 20.

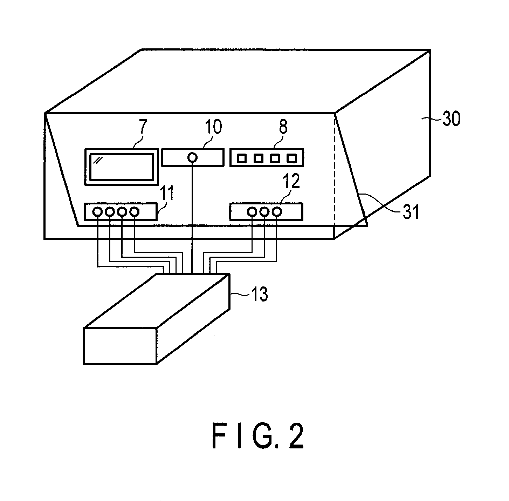

FIG. 2 is a perspective view showing an example of an exterior of the digital protection relay according to the embodiment.

An auxiliary transformer secondary input contact 11 and a relay test trip output contact 12 are used as test contacts (test terminals) of the digital protection relay. The auxiliary transformer secondary input contact 11 functions as an input contact for a relay test. As shown in FIG. 2, the test contacts are provided on a front surface of a panel 30 of the digital protection relay together with a terminal of the communication circuit 10. The front surface of the panel 30 is covered with an openable cover 31. The communication circuit 10, auxiliary transformer secondary input contact 11, and relay test trip output contact 12 may be covered with a single cover while the display circuit 7 and switch circuit 8 are exposed. By covering the contacts, unnecessary contact with the contacts can be prevented.

When a test using the digital protection relay is not conducted, an operator can close the cover. When a test is conducted, an operator can open the cover and connect a portable test device 13 to the test contacts and the terminal of the communication circuit 10. The portable test device 13 can be carried by an operator who conducts the operational test of the digital protection relay.

While receiving an electrical signal from the main circuit transformer 1, the detection resistance circuits 20a, 20b, and 20c input a test signal, such as an overcurrent for an operational test of the digital protection relay, to the analog detection circuit 3 with higher priority than an electrical signal from the main circuit.

The detection resistance circuits 20a, 20b, and 20c are Π-type circuits. The primary sides of the detection resistance circuits 20a, 20b, and 20c have one-to-one connections with terminals corresponding to phases on the output side of the auxiliary transformer 2.

One secondary side terminal of each of the detection resistance circuits 20a, 20b, and 20c has a one-to-one connection with a terminal corresponding to each phase on the input side of the analog detection circuit 3. The other secondary side terminal of each of the detection resistance circuits 20a, 20b, and 20c is connected to the auxiliary transformer secondary input contact 11.

In the present embodiment, the detection resistance circuits 20a, 20b, and 20c between the auxiliary transformer 2 and the analog detection circuit 3 are Π-type circuits. Each Π-shaped circuit includes a combination of a first resistor, a second resistor, and a third resistor.

The first resistor is on the side of the auxiliary transformer 2 in the Π-type circuit. The second resistor is in the middle in the Π-type circuit. The third resistor is on the side of the analog detection circuit 3 in the Π-type circuit.

One end of the first resistor is connected to one end (on the side of the auxiliary transformer 2) of the second resistor. The other end of the first resistor is connected to the auxiliary transformer secondary input contact 11.

One end of the third resistor is connected to the other end (on the side of the analog detection circuit 3) of the second resistor. The other end of the third resistor is connected to the auxiliary transformer secondary input contact 11.

With this configuration, a test signal can be input by a constant voltage to one end of the third resistor (the other end of the second resistor) in a state where an electrical signal from the main circuit transformer 1 is input to the first resistor. Thus, the second resistor can bear the difference between the voltage applied from the main circuit transformer 1 via the auxiliary transformer 2 to the first resistor and the voltage applied to the third resistor as a constant voltage.

In the present embodiment, this configuration enables input of a test signal to the analog detection circuit 3 with higher priority than an electrical signal from the main circuit transformer 1 even in the state where the electrical signal from the main circuit transformer 1 is input to the detection resistance circuits 20a, 20b, and 20c.

The detection resistance circuits 20a, 20b, and 20c may be T-type circuits equivalent to Π-type circuits.

The analog detection circuit 3 detects a current value output from the auxiliary transformer 2 via the detection resistance circuits 20a, 20b, and 20c. The detected current value is an analog value. The A/D conversion circuit 4 converts the analog current value from the analog detection circuit 3 into a digital current value.

The CPU 5 performs a protection operation of the digital protection relay by processing the current value from the A/D conversion circuit 4.

The memory 6, display circuit 7, and switch circuit 8 are connected to the CPU 5. The CPU 5 stores in and reads out from the memory 6 the current value, which is a reference for the protection operation, and various data. The display circuit 7 displays, for example, an abnormality of the main circuit. The switch circuit 8 comprises a digital protection relay for receiving a predetermined operation. This operation is one for setting or changing the current value used as a reference for performance of the protection operation.

The breaker trip output contact 9 for operating the breaker 21 connected to the main circuit is connected to the CPU 5. The breaker trip output contact 9 is connected to the relay test trip output contact 12. The relay test breaker trip output contact 12 is a test terminal which branches off from the breaker trip output contact 9. In the breaker trip output contact 9, a first trip output contact 9a is connected in series with a second trip output contact 9b. If those contacts are both operated to cause a short circuit, the trip coil (TC) of the breaker 21 is excited. Accordingly, the main circuit is protected.

The communication circuit 10 is connected to the CPU 5. The communication circuit 10 can transmit predetermined information to an external central monitoring device, which is not shown. The predetermined information indicates whether there is a change in the current value used as a reference for performance of the protection operation, or whether the breaker trip output contact 9 is closed.

In a test of the digital protection relay, an operator can connect the portable test device 13, which serves as a digital protection relay test device, to the communication circuit 10, auxiliary transformer secondary input contact 11, and relay test trip output contact 12.

As described above, the communication circuit 10, auxiliary transformer secondary input contact 11, and relay test trip output contact 12 of the digital protection relay are provided on the front surface of the panel of the digital protection relay. Therefore, the operator can easily connect the portable test device 13 to the digital protection relay.

The portable test device 13 comprises a test signal generation circuit 13a. The test signal generation circuit 13a has a function of outputting a test signal. The test signal is, for example, an overcurrent for checking the operation of the digital protection relay.

An operator can perform, at the portable test device 13, setting of selecting a phase to be tested from the three phases. The portable test device 13 can output a test signal between a predetermined detection resistance circuit and the analog detection circuit 3. The predetermined detection resistance circuit is a circuit corresponding to the selected phase of the detection resistance circuits 20a, 20b, and 20c.

As described above, the auxiliary transformer secondary input contact 11 of the digital protection relay is connected to the input side of the analog detection circuit 3. An electrical signal of a voltage at an electronic circuit level (equal to or less than several volts) can be used as the electrical signal applied to the digital protection relay for the operational test. Consequently, the size of the portable test device 13 can be greatly reduced in comparison to conventional test devices.

In addition, the portable test device 13 has an input determination function for an input from the breaker trip output contact 9 of the digital protection relay, and a communication function for communication with the communication circuit 10 of the digital protection relay. The communication function will be described later.

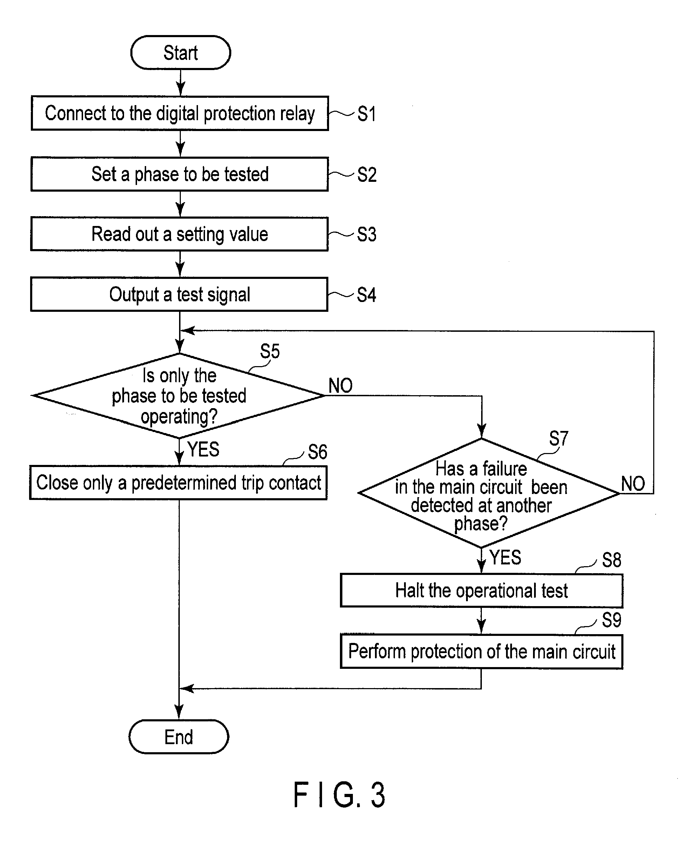

Next, the operation of the digital protection relay and the function of the portable test device will be described. FIG. 3 is a flowchart showing an example of an operational procedure of the portable test device of the digital protection relay according to the present embodiment.

To conduct the operational test of the digital protection relay, an operator connects a terminal of the test signal generation circuit 13a of the portable test device 13 to the auxiliary transformer secondary input contact 11 of the digital protection relay. The operator also connects a terminal for protection relay operation detection of the portable test device 13 to the relay test trip output contact 12 of the digital protection relay. The operator also connects the portable test device 13 to the communication circuit 10 of the digital protection relay (step S1).

In a test of the digital protection relay, the portable test device 13 sets multiple types of test conditions, such as a current/voltage value, test time, and output contact, and a phase desired to be tested of the three phases by a predetermined operation of the operator (step S2).

The portable test device 13 changes a setting value of the digital protection relay by communication via the communication circuit 10 based on the test conditions set in step S1.

The portable test device 13 reads a current setting value of the digital protection relay from the memory 6 through communication of the communication circuit 10 (step S3). Based on the current setting value, the portable test device 13 outputs a test signal of a constant voltage corresponding to a protection operation level of the protection relay from the test signal generation circuit 13a (step S4). The output test signal is input to the analog detection circuit 3 of the digital protection relay via a contact corresponding to the phase to be tested in the auxiliary transformer secondary input contact 11 of the digital protection relay. The test signal is input to the CPU 5 via the A/D conversion circuit 4.

The CPU 5 determines whether there is a trip output for performing protection processing of the digital protection relay in accordance with the current setting value of the digital protection relay. Based on the determination, the CPU 5 operates a relay corresponding to the phase to be tested.

In the test of the digital protection relay of the present embodiment, there is a case where an output value from the test signal generation circuit 13a of the portable test device 13 to the phase to be tested exceeds a predetermined threshold in a state where an abnormality of the main circuit is not detected.

The state where an abnormality of the main circuit is not detected is a state in which, of the three phase inputs to the main circuit system, the current/voltage input values of the phases other than the phase to be tested do not exceed a predetermined threshold.

The predetermined threshold is a value indicating that the protection operation for the phase to be tested is normal.

When the output value to the phase to be tested exceeds the predetermined threshold, only the phase to be tested is operating among the three phases. In this case (YES in step S5), the CPU 5 closes one of the first trip output contact 9a and the second trip output contact 9b, for example, the first trip output contact 9a only. In this case, the CPU 5 does not close the other trip output contact.

Accordingly, it is possible to conduct an operational test of a protection relay of one arbitrary phase without exciting the trip coil of the breaker 21.

Furthermore, the portable test device 13 detects an operation of the digital protection relay via the relay test trip output contact 12 of the digital protection relay (step S6). Therefore, it is possible to conduct an operational test of a digital protection relay while continuing the protection operation of the main circuit without powering off the main circuit.

Regarding the phases other than the arbitrary one determined as a subj ect of the protection relay operational test, i.e., the remaining two phases which are not subjects of the protection relay operational test, the CPU 5 monitors an input from the main circuit transformer 1 during the operational test of the digital protection relay.

The CPU 5 performs a predetermined determination regardless of whether the output value from the test signal generation circuit 13a of the portable test device 13 to the phase to be tested exceeds a predetermined threshold indicating that the protection operation for the phase is normal. The predetermined determination is a determination of whether, of the three phase inputs to the main circuit system, the current/voltage input values of the phases other than the phase to be tested exceed a predetermined threshold as a result of a failure which occurs in the main circuit during monitoring.

In the case of "YES" in step S7, the CPU 5 outputs a signal indicating that the current/voltage input values of the phases other than the phase to be tested have exceeded the predetermined threshold to the portable test device 13 through the communication circuit 10, and stops the output of the test signal from the portable test device 13. Accordingly, the CPU 5 halts the operational test of the digital protection relay (step S8).

The CPU 5 switches the input to the phase to be tested from the input from the portable test device 13 to the input from the main circuit, and closes both the trip output contacts 9a and 9b connected in series. In this manner, the CPU 5 performs a protection operation so that a trip signal is output to the outside (step S9). Therefore, it is possible to check the digital protection relay while continuing protection of the main circuit without powering off the main circuit.

As described above, the digital protection relay of the present embodiment comprises the analog detection circuit for detecting the quantity of electricity of the main circuit system to be protected. The digital protection relay can detect an abnormal state of the main circuit system, perform a protection operation by outputting a trip signal for operating the breaker, and conduct an operational test of the digital protection relay using a test signal at an electronic circuit level input from the secondary side of the auxiliary transformer. Accordingly, the test device can be made portable (reduced in size).

In addition, since terminals necessary for the test are provided on the front surface of the panel of the digital protection relay, an operator can easily connect the terminals necessary for the test to the digital protection relay to conduct an operational test.

The reliability of the auxiliary transformer 2 is greater than that of the main circuit transformer 1. Even if the auxiliary transformer 2 fails, the failure is in a break direction. Thus, the CPU 5 of the digital protection relay can detect an abnormality in the main circuit system. Consequently, an operator need not make a regular check of the auxiliary transformer 2 similar to that of the main circuit transformer 1.

The portable test device 13 applies a small test signal at an electronic circuit level corresponding to the protection operation level of the relay to a phase to be tested of the current/voltage inputs of the three phases on the secondary side of the auxiliary transformer 2. The digital protection relay produces an output set for each phase. Accordingly, an operational test for each phase can be conducted.

The above embodiment can provide a digital protection relay, a digital protection relay test device, and a digital protection relay test method which enable a safe and easy operational test without powering off the main circuit in advance.

While a certain embodiment has been described, this embodiment has been presented by way of example only, and is not intended to limit the scope of the inventions. Indeed, the novel embodiment described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. A digital protection relay, comprising:
an auxiliary transformer which decreases a voltage of an electrical signal from a main circuit transformer connected to a main circuit to a predetermined voltage;
a detection resistance circuit including a Π-type or T-type circuit including an input connected to an output of the auxiliary transformer;
an analog detection circuit which is connected to an output of the detection resistance circuit and detects a quantity of electricity of an electrical signal from the auxiliary transformer;
an A/D conversion circuit connected to the analog detection circuit;
a central processing unit which is connected to the A/D conversion circuit and performs a protection operation; and
a trip output contact which is closed by processing of the central processing unit and operates an external breaker,
wherein an input contact terminal for inputting a test signal with a constant voltage from an external test device to the analog detection circuit as a signal corresponding to an output of the auxiliary transformer is provided between the detection resistance circuit and the analog detection circuit, the input contact terminal corresponding to each phase on an input side of the analog detection circuit.

2. The digital protection relay of Claim 1,
further comprising a trip output contact terminal branched off from the trip output contact.

3. The digital protection relay of Claim 2,
wherein the input contact terminal and the trip output contact terminal are provided on a front surface of a panel.

4. The digital protection relay of Claim 2,
further comprising a plurality of trip output contacts connected in series, one of which is the trip output contact,
wherein the central processing unit closes part of the plurality of trip output contacts while opening a remaining part of the plurality of trip output contacts as a normal operation responsive to an input of the test signal.

5. The digital protection relay of Claim 4,
wherein the central processing unit inputs the test signal from an arbitrary one of three phases on an output side of the analog detection circuit, inputs a signal from the main circuit transformer without inputting the test signal from two remaining phases of the three phases, and closes all of the trip output contacts when an input value of a signal from either one of the two remaining phases exceeds a threshold indicating an abnormality of the main circuit.

6. A digital protection relay test device connected to the input contact terminal and the trip output contact terminal of the digital protection relay of Claim 2, wherein the digital protection relay test device inputs the test signal from the input contact terminal corresponding to an arbitrary one of three phases on an input side of the analog detection circuit, and conducts a test for detecting closing of the trip output contact responsive to an input of the test signal via the trip output contact terminal.

7. The digital protection relay test device of Claim 6,
wherein the digital protection relay test device detects a setting value of the digital protection relay, changes the detected setting value based on various types of predetermined test conditions, and conducts a closing test of the trip output contact based on the changed setting value.

8. The digital protection relay test device of Claim 6,
wherein the digital protection relay test device inputs the test signal to an arbitrary one of three phases on an output side of the analog detection circuit of the digital protection relay, and halts input of the test signal when, in a state of inputting a signal from the main circuit transformer to the two remaining phases of the three phases without inputting the test signal to the two remaining phases, the digital protection relay detects that an input value of a signal to either one of the two remaining phases exceeds a threshold indicating an abnormality of the main circuit.

9. A digital protection relay test method, comprising
inputting the test signal from the input contact terminal corresponding to an arbitrary one of three phases on an input side of the analog detection circuit of the digital protection relay of Claim 2, and conducting a test for detecting closing of the trip output contact responsive to an input of the test signal via the trip output contact terminal.

10. The digital protection relay test method of Claim 9, further comprising
detecting a setting value of the digital protection relay, changing the detected setting value based on various types of predetermined test conditions, and conducting a closing test of the trip output contact based on the changed setting value.

11. The digital protection relay test method of Claim 9, further comprising
inputting the test signal to an arbitrary one of three phases on an output side of the analog detection circuit of the digital protection relay, and halting input of the test signal when, in a state of inputting a signal from the main circuit transformer to the two remaining phases of the three phases without inputting the test signal to the two remaining phases, the digital protection relay detects that an input value of a signal to either one of the two remaining phases exceeds a threshold indicating an abnormality of the main circuit.
